# EUROPEAN PATENT APPLICATION

(11) **EP 2 129 196 A1**
(43) Date of publication of application: **02.12.2009**
(21) Application number: 06822729.7
(22) Date of filing: 31.10.2006
(51) Int. Cl.: H05K 3/00, H05K 1/02, H05K 1/03

(54) **CERAMIC MEMBER, METHOD OF FORMING GROOVE IN CERAMIC MEMBER, AND SUBSTRATE FOR ELECTRONIC PART**

(71) Applicant: Kyocera Corporation, Kyoto-shi Kyoto 612-8501 (JP)
(72) Inventor: MATSUSAKI, Takahiro, Satsumasendai-shi Kagoshima 895-0211 (JP)
(74) Representative: HOFFMANN EITLE
(86) International application number: PCT/JP2006/321800
(87) International publication number: WO 2008/062496

(57) **Abstract**

This invention relates to a ceramic member having a groove. In the ceramic member comprises, the content of silica or yttria is higher in a region located at depths at least ranging from 1 to 10 µm along a normal direction from a surface of the groove than in an another region located at depths ranging from 60 µm to 70 µm along the normal direction from the surface of the groove. The region located at depths at least ranging from 1 µm to 10 µm along the normal direction from the surface of the groove forms a surface layer, and the content of silica or yttria in the surface layer is 1.2 to 1.6 times the average content of silica or yttria in the another region located at depths ranging from 60 µm to 70 µm along the normal direction from the surface of the groove.

## Description

### TECHNICAL FIELD

The invention relates to a ceramic member having a groove, such as a ceramic member having a groove or grooves along which the ceramic member may be divided into a plurality of substrates for electronic parts. The invention also relates to a method of forming a groove or grooves in a ceramic member and to a ceramic substrate for electronic parts.

### BACKGROUND ART

A method for efficiently producing substrates for electronic parts generally includes forming a patterned conductor on a ceramic member having dividing grooves and then dividing the ceramic member along the dividing grooves into a large number of pieces.

Dividing grooves in a ceramic member are dominantly formed by pressing a blade attached to a die against an unbaked ceramic green sheet. The ceramic green sheet is then baked, and therefore, a problem may occur in which the dimensional accuracy may be poor due to uneven contraction of the product during sintering. On the other hand, a large ceramic member is necessary to produce a large number of substrates for electronic parts at once. However, such a large ceramic member may have a more serious problem with dimensional accuracy.

Dividing grooves are also formed by a method of applying laser beams to a work piece. Such a laser machining method includes a technique called laser abrasion. In this method, the work piece is locally melted and vaporized by laser irradiation so that a component of the work piece is removed from the laser-irradiated portion, and a groove can be formed by moving a laser spot (see for example Patent Document 1).

The ceramic member mainly includes a ceramic material and contains a sintering aid. Therefore, when the laser machining method is performed on the ceramic member, the laser beam-irradiated portion is instantaneously and explosively removed, and a large amount of a component added as the sintering aid is vaporized and lost from a surface of the groove.

Patent Document 1: Japanese Patent Application Laid-Open (JP-A) No. 2006-198664

### DISCLOSURE OF THE INVENTION

### PROBLEMS TO BE SOLVED BY THE INVENTION

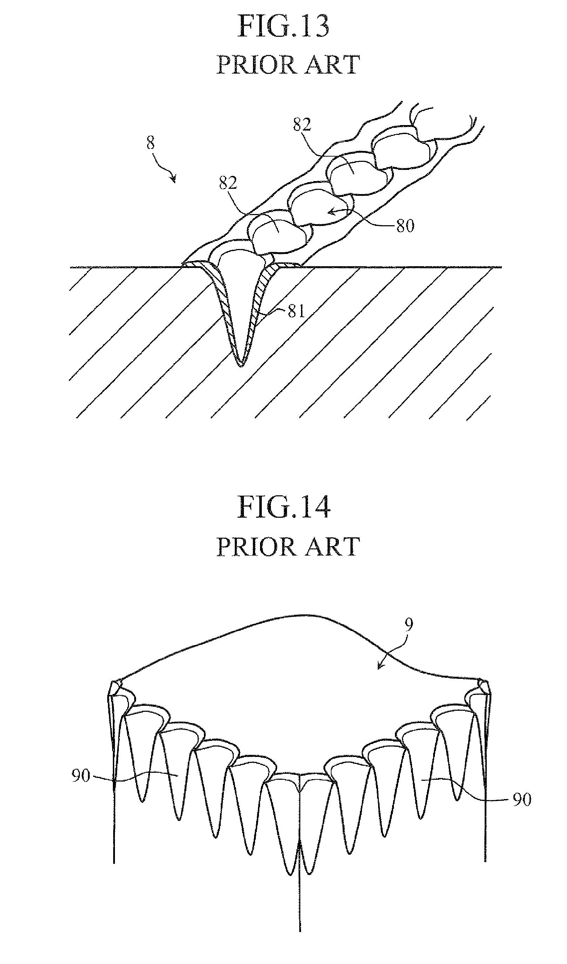

In the laser abrasion method, however, the work piece is processed at a temperature higher than the boiling point of its main component, so that as shown in Fig. 13, a surface layer 81 of a groove 80 significantly loses a sintering aid such as silica so as to become silica-poor. As a result, bonding between grains of the main ceramic component is reduced in the surface layer 81 of the groove 80. Therefore, a piece obtained by dividing the ceramic member 8 along the groove 80, such as a substrate for electronic parts, can be easily chipped at its end face formed by the dividing process, upon contact with something or the like.

When a groove 80 is formed in a relatively thick ceramic member 8, high power is necessary, and therefore, pulsed oscillation of a high-power laser such as a CO₂ laser has to be used. When the ceramic member 8 is processed at a temperature equal to or higher than the melting point of its main component using such a high-power laser beam, the groove 80 is formed of a plurality of spots 82 overlapping in the moving direction of the laser beam like a perforated line. As shown in Fig. 14, therefore, a piece obtained by dividing the ceramic member 8 along the groove 80, such as a substrate for electronic parts, has a ripple-shaped end face 90, which is formed by the dividing process. The piece 9 having the rippled-shaped end face 90 can be not only easily chipped at the end face upon contact with something or the like but also reduced in transverse strength.

### Means for Solving the Problems

The present invention provides a ceramic member which includes silica and has a groove. The content of silica is higher in a region located at depths at least ranging from 1 to 10 µm along a normal direction from a surface of the groove than in an another region located at depths ranging from 60 µm to 70 µm along the normal direction from the surface of the groove. The region located at depths at least ranging from 1 µm to 10 µm along the normal direction from the surface of the groove forms a surface layer, and the content of silica in the surface layer is 1.2 to 1.6 times the average content of silica in the another region located at depths ranging from 60 µm to 70 µm along the normal direction from the surface of the groove.

The ceramic member of the present invention includes alumina as a main component. The ceramic member has an average alumina content of 92.6% by mass to 99.6% by mass and an average silica content of 0.3% by mass to 5.0% by mass.

The ceramic member of the present invention includes calcia and magnesia, wherein the ceramic member has an average calcia content of 0% by mass to 0.4% by mass and an average magnesia content of 0.1% by mass to 2.0% by mass.

The present invention further provides a ceramic member which includes yttria and has a groove. The content of yttria is higher in a region located at depths at least ranging from 1 to 10 µm along a normal direction from the surface of the groove than in an another region located at depths ranging from 60 µm to 70 µm along the normal direction from the surface of the groove. The region located at depths at least ranging from 1 µm to 10 µm along the normal direction from the surface of the groove forms a surface layer, and the content of yttria in the surface layer is 1.2 to 1.6 times the average content of yttria in the another region located at depths ranging from 60 µm to 70 µm along the normal direction from the surface of the groove.

The ceramic member of the present invention may include zirconia as a main component. The region located at depths ranging from 60 µm to 70 µm along the normal direction from the surface of the groove has an average zirconia content of 94.2% by mass to 94.8% by mass and an average yttria content of 5.2% by mass to 5.8% by mass.

The ceramic member of the present invention is for a plurality of substrates for electronic parts by being divided into along the groove.

The present invention also provides a method of forming a groove in a ceramic member. The method includes: applying a heat ray to a surface of the ceramic member, while blowing gas thereto; and moving the heat ray. The ceramic member includes alumina as a main component and silica, and a portion to which the heat ray is applied has a temperature of 2050°C to 2980°C. Preferably, the portion to which the heat ray is applied has a temperature of 2100°C to 2900°C.

The ceramic member may include zirconia as a main component and yttria. In this instance, the portion to which the heat ray is applied has a temperature of 3300°C to 4400°C. Preferably, the portion to which the heat ray is applied has a temperature of 3350°C to 4300°C.

The heat ray is moved at a speed of 9 m/minute to 70 m/minute. Preferably, the heat ray is moved at a speed of 10 m/minute to 60 m/minute.

The heat ray has a frequency of 10000 Hz or more.

The heat ray is a laser beam.

The gas is blown from a direction oblique to a normal direction of the surface of the ceramic member. Preferably, the gas is blown from a direction making an angle of 15° to 75° with the normal direction.

The present invention also provides a substrate for electronic parts which includes a ceramic member including silica. In the substrate for electronic parts, at least part of a peripheral portion on at least one of the main side and the back side of the substrate, the content of silica is higher in the region located at depths at least ranging from 1 to 10 µm along a normal direction from a surface of a groove than in the another region located at depths ranging from 60 µm to 70 µm along the normal direction from a surface of a groove.

The present invention further provides a substrate for electronic parts which includes a ceramic member including yttria. In the substrate for electronic parts, at least part of a peripheral portion on at least one of the main side and the back side of the ceramic member, the content of yttria is higher in the region located at depths at least ranging from 1 to 10 µm along a normal direction from a surface of a groove than in the another region located at depths ranging from 60 µm to 70 µm along the normal direction from a surface of a groove.

### Effects of the Invention

In the conventional laser machining, grooves are formed at a temperature such that the main ceramic component is vaporized, and therefore, a surface layer of the grooves in the ceramic member is significantly reduced in the content of a sintering aid having a boiling point lower than that of the main ceramic component. In particular, such a sintering aid as silica or yttria is significantly reduced, so that mutual bonding strength between ceramic grains of the main component is reduced. As a result, the surface layer of the grooves has low strength, because of a shortage of the sintering aid.

In contrast, in the ceramic member of the invention, the content of silica or yttria in the region located at depths at least ranging from 1 µm to 10 µm (surface layer) is higher than the average content of it in the region located at depths ranging from 60 µm to 70 µm along the normal direction from the surface of the groove. Silica or yttria is a sintering aid that may be used to form a sintered ceramic material mainly including alumina or zirconia. Therefore, if the content of a sintering aid such as silica or yttria in the surface layer is high, mutual bonding strength between grains of alumina or zirconia will be high in the surface layer. As a result, when the ceramic member of the invention is divided into pieces, each piece is prevented from chipping at its end face and has high transverse strength.

In the substrate for electronic parts of the invention, the content of silica or yttria in the surface layer is also higher than the average content of it in the whole of the substrate, so that it is prevented from chipping at its end face and has high transverse strength.

In the groove-forming method of the invention, a groove is formed by applying a heat ray to a ceramic member mainly including alumina or zirconia so that the surface of the ceramic member can have a temperature within a given range. According to the invention, a sintering aid such as ceria or yttria is first melted, before the melting temperature of the main component of the ceramic member, such as alumina or zirconia, is reached. Therefore, the melted sintering aid can be infiltrated into the inside, while reacting with the crystal grains of the main component forming the surface layer of the groove. Subsequently, the main component is melted, but the melted main component is pushed out of the heat ray-irradiated portion by blowing gas, so that a groove is formed in the ceramic member. Since the sintering aid is first melted and infiltrated into the groove, the surface layer of the groove has a relatively high sintering aid concentration. In the ceramic member having a groove formed according to the invention, therefore, mutual bonding strength between grains of the main component such as alumina or zirconia is high in the surface layer of the groove. Therefore, when the ceramic member is divided along the groove into pieces, each piece is prevented from chipping at its end face and has high transverse strength.

The groove-forming method of the invention can also reduce the energy density necessary to keep the temperature of a ceramic member surface within a given range.
Therefore, the groove can be formed at a higher speed in the ceramic member so that the productivity can be improved. In addition, when the heat ray is applied at a reduced energy density, a continuous groove stable in width and depth can be formed. As a result, each piece obtained by dividing the ceramic member along the groove has a smooth fracture surface, so that its transverse strength is also improved.

### BRIEF DESCRIPTION OF DRAWINGS

Fig. 1 is a whole perspective view showing an example of the ceramic member of the invention.
Fig. 2 is a cross-sectional view along line II-II of Fig. 1.
Fig. 3 is a whole perspective view showing an example of the substrate for electronic parts of the invention.
Fig. 4 is a cross-sectional view along line IV-IV of Fig. 2.
Fig. 5 is a whole perspective view for illustrating a method of forming grooves in a ceramic member.
Fig. 6 is a perspective view showing the principal part in an enlarged manner to illustrate the method of forming grooves in the ceramic member.
Fig. 7 is a front view showing the principal part in an enlarged manner to illustrate the method of forming grooves in the ceramic member.
Fig. 8 is a graph for illustrating an example of the pulse waveform used for laser beam radiation.
Fig. 9 is a perspective view showing the principal part to illustrate a method for evaluation of chipping.
Fig. 10 is a front view for illustrating a method for measurement of transverse strength.
Fig. 11a is an SEM photograph showing the state of Sample No. 3 before the solidified melt is removed from Sample No. 3, and Fig. 11B is an SEM photograph showing the state of Sample No. 3 after the solidified melt is removed from Sample No. 3.
Fig. 12 a is an SEM photograph showing the state of Sample No. 19 before the solidified melt is removed from Sample No. 19, and Fig. 12b is an SEM photograph showing the state of Sample No. 19 after the solidified melt is removed from Sample No. 19.
Fig. 13 is a perspective view showing the principal part of a structure of a ceramic member having a groove formed by a conventional laser machining method.
Fig. 14 is a perspective view showing the principal part of a piece obtained by cutting the ceramic member of Fig. 13 along the groove.

### DESCRIPTION OF REFERENCE SYMBOLS

1 represents a ceramic member
2 groove
20 surface layer (of the groove)
21 surface (of the groove)
3 substrate for electronic part
31 main surface (of the substrate for electronic part)
32 periphery (of the substrate for electronic part)
33 surface layer (of the periphery)

### BEST MODE FOR CARRYING OUT THE INVENTION

The invention is described below with reference to the drawings.

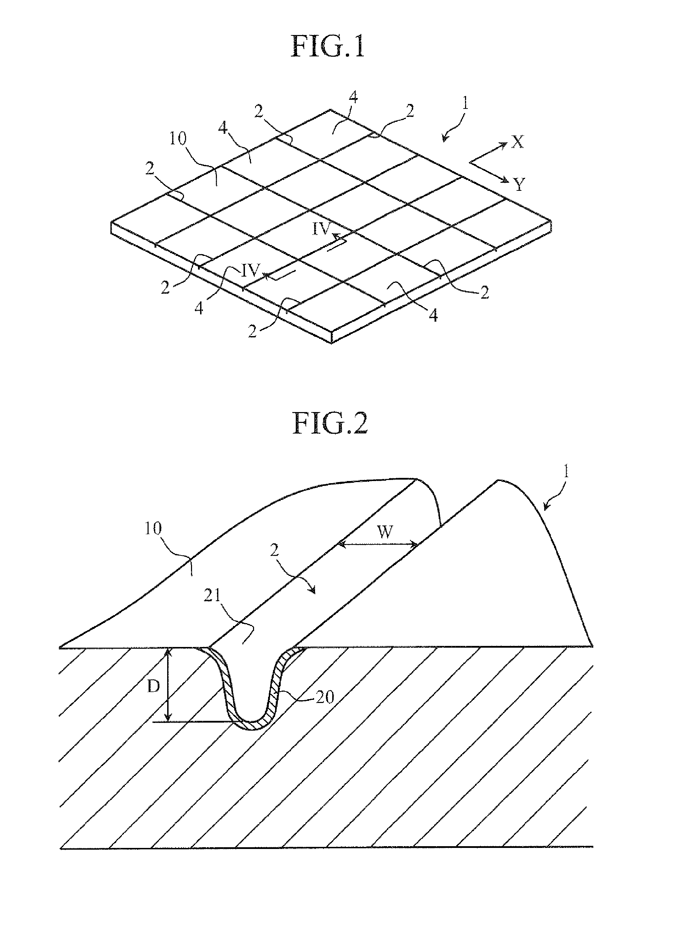

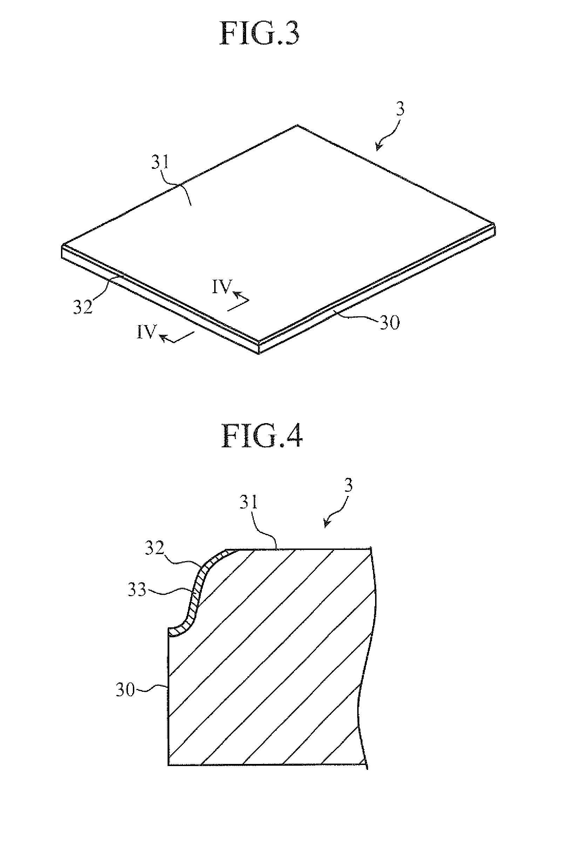

A ceramic member 1 shown in Figs. 1 and 2 have a plurality of grooves 2, which are used to divide it into a plurality of substrates for electronic parts 3, one of which is shown in Figs. 3 and 4. The ceramic member 1 has a patterned conductor (not shown) formed in each area 4 defined by the grooves 2 as shown in Figs. 3 and 4. After the grooves 2 are formed, the patterned conductor may be formed by forming a film by screen printing, thin film vapor deposition, or the like and baking the film at a specific temperature.

The ceramic member 1 includes a ceramic material, such as alumina or zirconia, as a main component, and contains a sintering aid such as silica or yttria. Besides alumina and zirconia, examples of the main component of the ceramic member 1 that may be used include mullite, steatite, forsterite, silicon nitride, and alumina-zirconia.

The average content of the main component in the ceramic member 1 (exclusive of the patterned conductor) may be from 92.6% by mass to 99.6% by mass for alumina in a region located at depths ranging from 60 µm to 70 µm along the normal direction from a surface 21 of the groove 2 or from 94.2% by mass to 94.8% by mass for zirconia in a region located at depths ranging from 60 µm to 70 µm along the normal direction from the surface 21 of the groove 2.

When alumina is the main component, silica may be used as a sintering aid. When zirconia is the main component, yttria may be used as a sintering aid. The average content of the sintering aid (exclusive of the patterned conductor) may be from 0.3% by mass to 5.0% by mass for silica in a region located at depths ranging from 60 µm to 70 µm along the normal direction from the surface 21 of the groove 2 or from 5.2% by mass to 5.8% by mass for yttria in a region located at depths ranging from 60 µm to 70 µm along the normal direction from the surface 21 of the groove 2. Besides silica or yttria, magnesia or calcia may be used as the sintering aid. The average contents of magnesia and calcia may be from 0% by mass to 0.4% by mass and from 0.1% by mass to 2.0% by mass, respectively, in a region located at depths ranging from 60 µm to 70 µm along the normal direction from the surface 21 of the groove 2.

The average content of the main component (such as alumina or zirconia) or the sintering aid (such as silica or yttria) in the region located at depths ranging from 60 µm to 70 µm along the normal direction from a surface of the groove may be measured by a process including etching the region located at depths ranging from 60 µm to 70 µm along the normal direction from the surface of the groove by FIB machining, while performing the measurement on a 50 µm square area using wavelength dispersive EPMA analysis. Alternatively, the average content of the main component or the sintering aid in the region may also be measured by a process including forming the cross-section of the region located at depths ranging from 60 µm to 70 µm along the normal direction from the surface of the groove and performing the measurement on a 5 µm square area using wavelength dispersive EPMA analysis. In the EPMA analysis, carbon or the like may be vapor-deposited on the surface to be measured, and the measurement conditions preferably include an accelerating voltage of 10 to 20 kV and a probe current of 2 × 10⁻⁷ to 4 × 10⁻⁷ A.

The grooves 2 are used to divide the ceramic member 1 into parts by application of a load to the ceramic member 1. The grooves 2 include a plurality of X grooves extending in the X direction and being equally spaced in the Y direction and a plurality of Y grooves extending in the Y direction and being equally spaced in the X direction. Therefore, the substrates for electronic parts 3 obtained by dividing the ceramic member 1 along the grooves 2 have the same shape.

For example, each groove 2 is formed to have a width W of 110 to 150 µm and a depth D of 120 to 180 µm. Each groove 2 has a surface layer 20, and the content of the specific sintering aid in the surface layer 20 is typically from 1.2 times to 1.6 times the average content of the sintering aid in the region located at depths ranging from 60 µm to 70 µm along the normal direction from the surface 21 of the groove 2. More specifically, when the ceramic member 1 mainly includes alumina, the content of ceria in the surface layer 20 is typically from 0.36% by mass to 8.0% by mass, or when the ceramic member 1 mainly includes zirconia, the content of yttria in the surface layer 20 is typically from 6.24% by mass to 9.28% by mass. When the content of silica or yttria in the surface layer 20 is from 1.2 times to 1.6 times the average content of silica or yttria in the region located at depths ranging from 60 µm to 70 µm along the normal direction from the surface 21 of the groove 2, an adequate amount of silica or yttria can be uniformly interposed between the ceramic particles in the surface layer 20 so that the ceramic member 1 can have a high level of sintered properties and strength.

The surface layer 20 of the groove 2 includes at least a region located at depths ranging from 0 to 10 µm along the normal direction from the surface 21 of the groove 2. In the definition of the content of silica or yttria in the surface layer 20, however, the content of silica or yttria in the region located at depths ranging from 0 to less than 1 µm along the normal direction from the surface 21 of the groove 2 may be ignored. This is because it is difficult to precisely determine the content of silica or yttria in the region from the surface 21 of the groove 2 to a depth of less than 1 µm due to contamination. As used herein, therefore, the content of silica or yttria in the surface layer 20 of the groove 2 means a value measured in the region located at depths ranging from 1 µm to 10 µm along the normal direction from the surface 20. The content of silica or yttria in the surface layer 20 of the groove 2 is preferably measured in the region located at depths ranging from 1 µm to 3 µm along the normal direction from the surface 21 of the groove 2.

The content of each component in the surface layer 20 of the groove 2 may be quantitatively analyzed in a 50 µm square region located at a specific depth by wavelength dispersive EPMA analysis (wavelength dispersive X-ray microanalyzer analysis). In the EPMA analysis, carbon is vapor-deposited on the surface to be measured, and the measurement conditions include an accelerating voltage of 15 kV and a probe current of 3.0 × 10⁻⁷ A.

Conventional laser beam machining to form grooves is performed at a temperature such that the ceramic main component can be vaporized. In the conventional process, therefore, the content of a sintering aid in the surface layer of a groove in a ceramic member is significantly reduced, because the sintering aid has a boiling point lower than that of the ceramic main component. In particular, a sintering aid of silica, yttria or the like is significantly reduced so that the bonding between the ceramic particles of the main component is reduced. As a result, the surface layer of grooves formed by conventional methods has low strength due to a sintering aid shortage.

In the ceramic member 1 of the invention, however, the content of silica or yttria in the surface layer 20 of the groove 2 is higher than that in the region located at depths ranging from 60 µm to 70 µm along the normal direction from the surface 21 of the groove 2. Silica or yttria is used as a sintering aid, when a ceramic material mainly including alumina or zirconia is produced by sintering. Therefore, the mutual bonding strength between alumina grains or zirconia grains in the surface layer 20 increases with increasing the content of a sintering aid such as silica or yttria in the surface layer 20. As a result, an end face 30 of the substrate for electronic parts 3 shown in Figs. 3 and 4 is prevented from chipping, when it is produced by dividing the ceramic member 1, and the substrate for electronic parts 3 has high transverse strength.

For example, a plurality of the grooves 2 shown in Figs. 1 and 2 may be formed as described below.

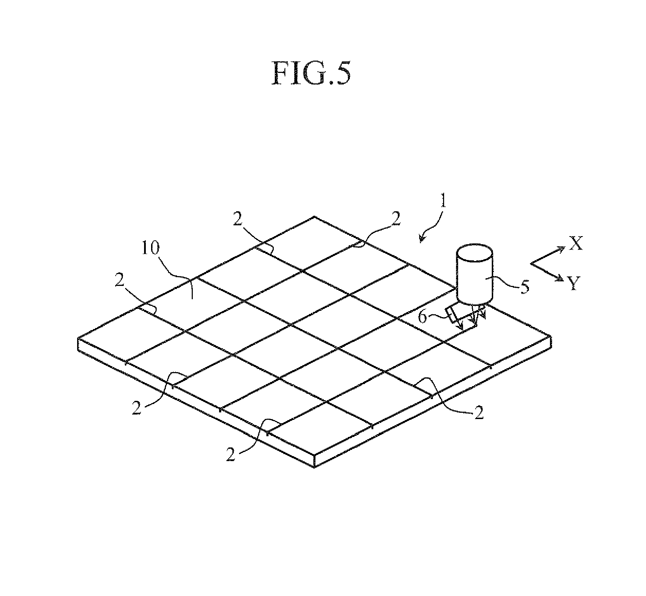

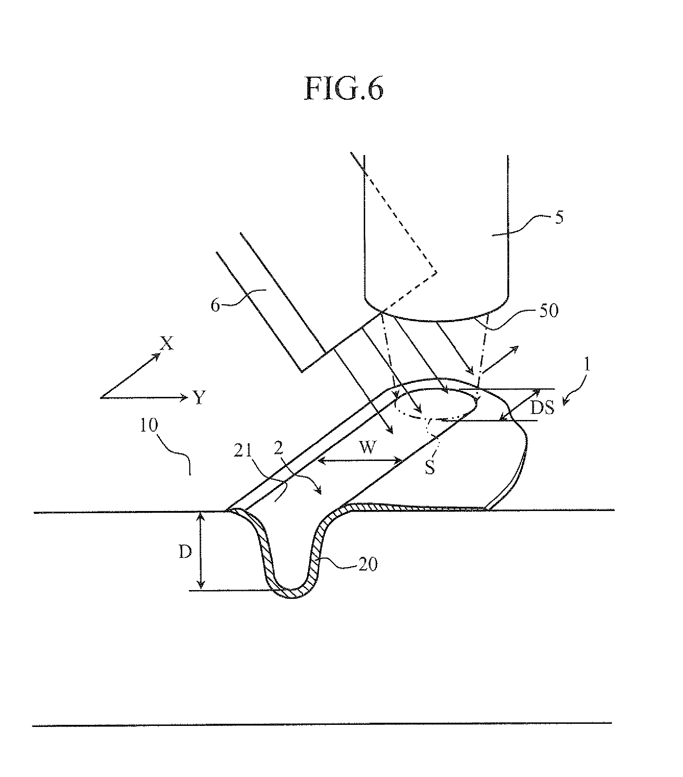

As shown in Figs. 5 to 7, the grooves 2 may be formed by a process that includes applying heat rays to the main surface 10 of the ceramic member 1, while blowing gas thereto, and moving the heat rays along a given path.

For example, the heat rays applied are laser beams. For example, a CO₂ laser oscillator, a nitrogen laser oscillator, an excimer laser oscillator, or a YAG laser oscillator may be used as a device 5 for emitting laser beams. In order to produce high-power laser beams, a CO₂ laser oscillator is preferably used. A distance L between the light-emitting face 50 of the laser oscillator 5 and the main surface 10 of the ceramic member 1 is typically set at around 1 cm. Of course, heat rays other than laser beams may be used to apply thermal energy to the main surface 10 of the ceramic member 1, when the grooves 2 are formed.

The laser beams may be applied to the ceramic member 1 in such a manner that the laser beam-irradiated portion has a temperature that is equal to or higher than the melting point of the main component of the ceramic member 1 and equal to or lower than the boiling point thereof. For example, such a temperature is from 2050°C to 2980°C, preferably from 2100°C to 2900°C, for the ceramic member 1 mainly including alumina, and from 3300°C to 4400°C, preferably from 3350°C to 4300°C, for the ceramic member 1 mainly including zirconia.

When the laser beam-irradiated portion has a temperature that is equal to or higher than the melting point of the main component of the ceramic member 1 and equal to or lower than the boiling point thereof, a target site of the ceramic member 1 can be adequately melted in the process of forming the grooves 2 so that vaporization of the main component and the sintering aid can be prevented. On the other hand, before the main component such as alumina or zirconia reaches its melting temperature, the sintering aid such as ceria or yttria is first melted in the laser beam-irradiated portion of the ceramic member 1. In the laser beam-irradiated portion, therefore, the melt of the sintering aid is infiltrated into the inside, while it reacts with crystal grains of alumina or zirconia. As a result, the content of the sintering aid in the surface layer of the groove 2 becomes higher than the average content of the sintering aid in the whole of the ceramic member 1. Therefore, the strength of mutual bonding between the grains of the main component such as alumina or zirconia becomes high in the surface layer 20 of the groove 2, so that chipping at the end face 30 can be prevented when the ceramic member 1 is divided along the grooves 2 into the substrates for electronic parts 3 (see Figs. 3 and 4) and that each piece obtained by dividing can have high transverse strength.

Since the sintering aid is infiltrated into the inside, the concentration of the sintering aid gently decreases with increasing the depth in the surface layer 20 of the groove 2. Therefore, the surface layer 20 of the groove 2 has no clear interface and no concentrated stress, which would otherwise be produced in the presence of an interface, so that the surface layer 20 advantageously resists peeling.

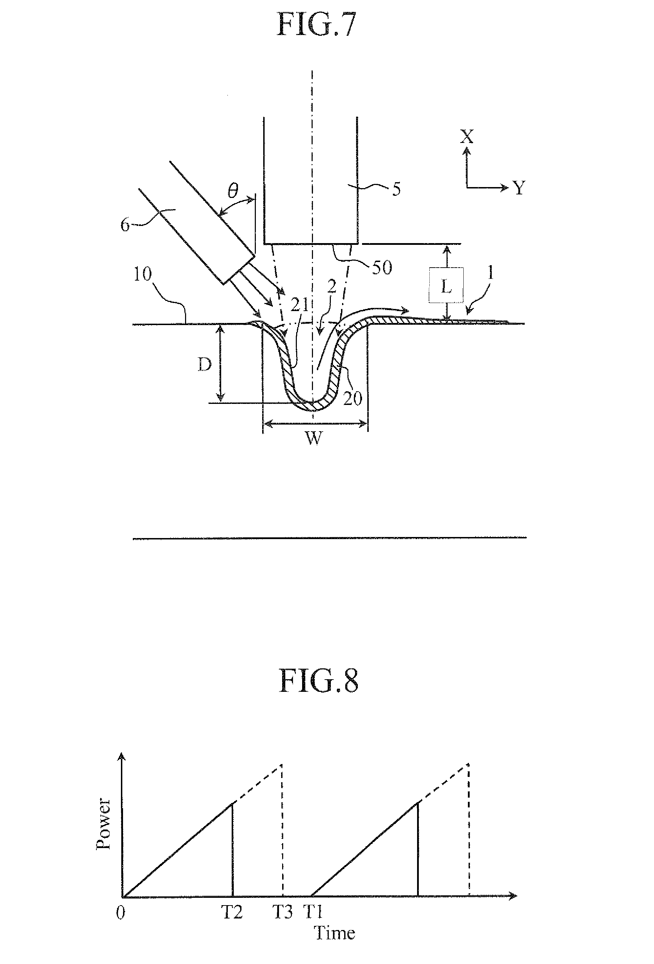

The temperature of the laser beam-irradiated portion may be determined depending on the power, oscillating frequency, DUTY, excitation time (response time), spot shape, and laser beam moving speed. Not all of these factors have to be variable. For example, the power, excitation time, and spot shape may be fixed, and the frequency, DUTY, and laser beam moving speed may be variable, when the temperature of the laser beam-irradiated portion is controlled. Herein, DUTY is a value expressed by 100 × (ON signal time T3)/( pulse period T1) (see Fig. 8).

When the power, excitation time and spot shape are fixed to be 200 W, 100 µsec, and a perfect circle 76 µm in diameter, respectively, a temperature of about 2000°C to about 4000°C, necessary for irradiation of the ceramic member 1 mainly including alumina or zirconia, can be achieved using an oscillating frequency of 9000 to 25000 Hz, a DUTY of 50 to 85%, and a moving speed of 8 to 70 m/minute.

The temperature of the laser beam-irradiated portion may be determined using a conversion table of the laser beam irradiation conditions to the temperature. The conversion table may be prepared by a process that includes preparing different standard samples with various materials whose melting temperature is from about 2000 to about 4000°C and irradiating each standard sample with laser beams under various laser beam irradiation conditions to examine the melting of the standard sample. Specifically, the conversion table may be prepared to correlate the process conditions at the beginning of the melting of the standard sample with the corresponding melting point of the standard sample. If possible, the temperature of the laser beam-irradiated portion may be directly or indirectly measured using no conversion table.

In this process, the moving speed of the laser beam spot S is typically from 9 m/minute to 70 m/minute, preferably from 10 m/minute to 60 m/minute. If the moving speed of the spot S is too low, more heat than necessary may be applied to the same portion so that the main component or the sintering aid may be partially eliminated, the surface layer 20 of the groove 2 may have a thermally-etched state as found in conventional laser-machined articles, and the temperature of the laser beam-irradiated portion may be equal to or higher than the boiling point of the ceramic main component. If the moving speed of the spot S is too high, it may be difficult to reduce the difference between the maximum and minimum values of the width of the groove 2. That is because existing pulse oscillation lasers have a laser power modulation limit of 25 kHz, and therefore, when laser machining is performed at a speed beyond the limit of the laser power modulation performance, the groove is formed like a perforated line (see Fig. 13) similarly to conventional laser-machined articles, due to the difference between the maximum and minimum values of the width W of the groove 2. Therefore, the moving speed of the spot S should be from 9 m/minute to 70 m/minute, preferably from 10 m/minute to 60 m/minute, so that the temperature of the laser beam-irradiated portion can be controlled to the desired temperature. As a result, vaporization of the ceramic member 1 can be prevented, which would otherwise be caused by excessive heat application, and the ceramic member 1 can be continuously melted to form the groove 2. Therefore, the resulting groove 2 is continuous and stable in width W and depth D. Since the groove 2 is not formed like a perforated line (see Fig. 13) as formed by conventional laser machining, a reduction in the transverse strength of each substrate for electronic parts 3 (see Figs. 3 and 4) can be prevented, when the ceramic member 1 is divided into the substrates for electronic parts 3.

As shown in Fig. 8, the pulse oscillation frequency for laser beam irradiation is preferably 5000 Hz or more (the pulse period T1 is preferably 200 µsec or less), more preferably 10000 Hz or more (the pulse period T1 is more preferably 100 µsec or less). The upper limit of the pulse frequency may be 25000 Hz (the pulse period T1 may be 40 µsec or less).

The waveform of the pulse that is preferably used may be such that the excitation time T2 is relatively long and the ON signal time T3 is relatively short, specifically such that the pulse period T1 is from 80 to 200 µsec, the excitation time T2 between the laser oscillation and reaching the maximum temperature range is from 80 to 200 µsec, and the ON signal time T3 is from 40 to 170 µsec, wherein T3 ≦ T 2 ≦ T1. In Fig. 8, the solid line indicates the history of the actually-controlled laser power, and the broken line indicates a hypothetical history until the completion T2 of the rise. In the laser beam oscillator 5, the OFF signal T3 is before the completion T2 of the rise, although the time to the completion of the rise is defined as the excitation time T2.

The laser beam oscillation with a pulse waveform of relatively short ON signal time T3 and relatively long excitation time T2 allows heat application with a controlled maximum temperature range. In addition, when the pulse period T1 is 200 µsec or less, the resulting laser pulse waveform is analogous to CW (Continuity Wave) continuous oscillation, and the grooves 2 formed using the pulse waveform exhibit reduced variations in the depth D and the width W.

On the other hand, gas is blown to the portion irradiated with heat rays such as laser beams in order to remove the melted ceramic material. The gas blowing is performed using a gas blowing apparatus 6.

The gas blowing apparatus 6 is capable of blowing gas to an area with a size larger than the spot diameter DS of the heat ray. For example, the area to which the gas is blown has a size 60 to 100 times the spot diameter DS of the laser beam in the laser beam moving direction, and a size 30 to 50 times the spot diameter DS in the direction perpendicular to the moving direction. The gas to be blown may be compressed air, argon gas, or oxygen gas. The gas blowing to such an area may be performed through an elliptical or rectangular gas outlet. In this case, the gas outlet may have a size of 2.0 to 3.3 mm in the long axis direction (the laser beam moving direction) and a size of 1.0 to 1.6 mm in the short axis direction (the direction perpendicular to the laser beam moving direction).

For example, the gas is blown at a pressure of 0.4 to 0.6 MPa. When the gas blowing pressure is set within such a range, the component melted by the laser beam irradiation can be well pushed out of the laser beam-irradiated portion so that a groove 2 with a smooth surface can be formed.

The gas may be blown in a direction parallel or oblique to the normal direction of the main surface 10 of the ceramic member 1, preferably in an oblique direction at a tilt angle 8 of 55° to 75° with respect to the normal direction. When the gas is blown in an oblique direction to the ceramic member 1, the melted or vaporized ceramic component is pushed to a side relative to the laser oscillator 5. Therefore, the melted or vaporized ceramic component is prevented from being deposited on the optical system such as the light emitting face 50 and from contaminating the optical system, even when the distance L between the light emitting face 50 of the laser oscillator 5 and the main surface 10 of the ceramic member 1 is set at around 1 cm.

After the grooves 2 are formed as described above, if necessary, a solidified melt deposited around the grooves 2 may be removed. For example, the solidified melt may be removed by cutting or laser etching.

The ceramic member 1 is divided along the grooves 2 into the substrates for electronic parts 3 shown in Figs. 3 and 4, as described above. The content of the sintering aid such as silica or yttria in the surface layer 20 of the groove 2 is higher than the average content of it in the region at depths ranging from 60 µm to 70 µm along the normal direction from the surface 21 of the groove 2. In the substrate for electronic parts 3 obtained by dividing the ceramic member 1, therefore, the content of the sintering aid such as silica or yttria in the surface layer 33 on a periphery 32 of a main surface 31 is higher than the average content of the substrate for electronic parts 3 (exclusive of a patterned conductor) in the region at depths ranging from 60 µm to 70 µm along the normal direction from the surface 21 of the groove 2.

More specifically, for example, the content of the sintering aid such as silica or yttria in the surface layer 33 on the periphery 32 of the main surface 31 is 1.2 to 1.6 times the average content of silica or yttria in the region at depths ranging from 60 µm to 70 µm along the normal direction from the surface 21 of the groove 2.

When the substrate for electronic parts 3 mainly includes alumina, for example, the region at depths ranging from 60 µm to 70 µm along the normal direction from the surface 21 of the groove 2 has an average alumina content of 92.6% by mass to 99.6% by mass, an average silica content of 0.3% by mass to 5.0% by mass, an average CaO content of 0% by mass to 0.4% by mass, and an average MgO content of 0.1% by mass to 2.0% by mass. For example, the content of silica in the surface layer 33 on the periphery 32 is from 0.36% by mass to 8.0% by mass.

When the substrate for electronic parts 3 mainly includes zirconia, for example, the region at depths ranging from 60 µm to 70 µm along the normal direction from the surface 21 of the groove 2 has an average zirconia content of 94.2% by mass to 94.8% by mass, an average yttria content of 5.2% by mass to 5.8% by mass. For example, the content of yttria in the surface layer 33 on the periphery 32 is from 6.24% by mass to 9.28% by mass.

The average content of each component in the region at depths ranging from 60 µm to 70 µm along the normal direction from the surface 21 of the groove 2 in the substrate for electronic parts 3 and the content of ceria or yttria in the surface layer 33 on the periphery 32 may be measured by the same method as described above for the ceramic member 1 (see Figs. 1 and 2).

In the substrate for electronic parts 3 described above, the mutual bonding strength between grains of the main component such as alumina or zirconia is relatively high, because the content of the sintering aid in the surface layer 33 on the periphery 32 of the main surface 31 is higher than the average content of it in the region at depths ranging from 60 µm to 70 µm along the normal direction from the surface 21 of the groove 2. Therefore, the substrate for electronic parts 3 can be prevented from chipping at the end face 30 and have high transverse strength. In addition, the grooves 2 of the ceramic member 1 can be formed as continuous grooves having a smooth surface, so that the end face 30 of the substrate for electronic parts 3 can be smooth. Therefore, chipping at the end face 30 can be more appropriately prevented, and higher transverse strength can be provided.

The embodiments described above are not intended to limit the scope of the invention, and various modifications thereof are possible. The embodiments described above relate to ceramic members for use in forming substrates for electronic parts. However, the ceramic member of the invention may also be used to form other articles than substrates for electronic parts.

### Example 1

In this example, grooves were formed in a sintered ceramic material mainly including alumina by applying a laser beam to the sintered ceramic material, and a study was performed on the influence of the temperature of the laser beam-irradiated portion on the transverse strength and chipping of a piece obtained by dividing the ceramic member along the grooves. In this example, the silica content was also measured in a region located at depths at least ranging from 1 µm to 10 µm along the normal direction from the surface of the groove and in a region located at depths ranging from 60 µm to 70 µm along the normal direction from the surface of the groove, and the cross-section of the groove and the vicinity thereof in the ceramic member was photographed by SEM.

### Preparation of Sintered Ceramic Material

The sintered ceramic material was prepared by a process including making a ceramic green sheet from a powder mixture including alumina powder as the main component, silica powder and magnesia powder as additives, and optionally added calcia powder, cutting the ceramic green sheet into a given shape, and then baking the cut piece at a temperature of about 1600°C. The sintered ceramic material was in the form of a rectangular plate of 152.4 mm × 152.4 mm × 0.635 mm.

### Formation of Grooves

Nine rectangular grooves each with a size of 50.8 mm × 50.8 mm were formed by a process including applying a laser beam to the main surface of the sintered ceramic material, while blowing gas thereto, and moving the portion to which the laser beam was applied.

Using a CO₂ laser oscillator, the laser beam was radiated in a pulse waveform with a relatively slow rise (T2=100 µsec) as shown in Fig. 8 and an ON signal time T3 of 50 µsec. The pulse period for the pulse oscillation frequency and the laser beam moving speed were as shown in Table 1.

In the gas blowing process, compressed air was blown to the laser beam-irradiated portion along the long axis at a pressure of 0.5 MPa and at a tilt angle θ of 70° with respect to the normal direction.

The solidified melt pushed out to the periphery of the groove by the gas blowing was removed by cutting and then evaluated as described later.

### Table 1

### Evaluation of Chipping

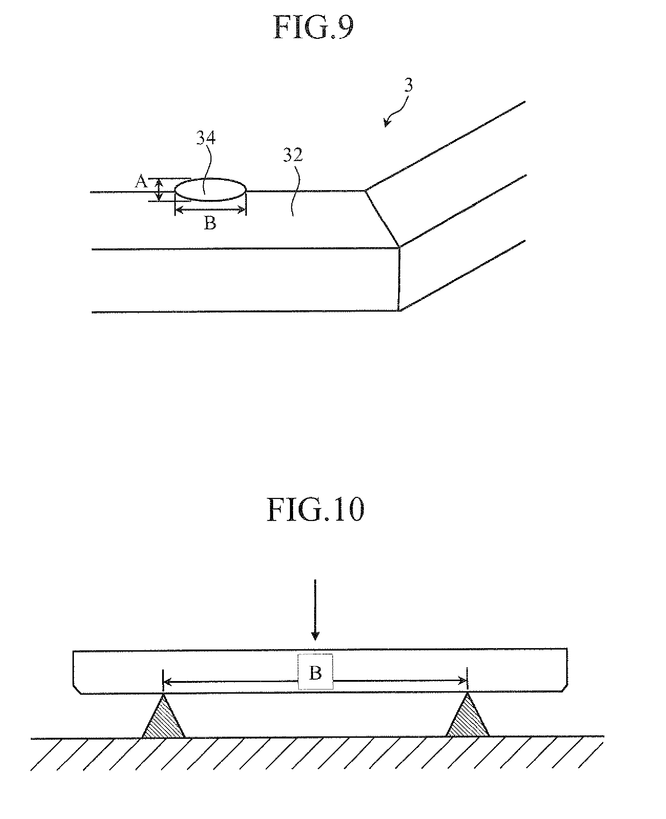

Chipping was evaluated by a process including dividing a plurality of ceramic members along the grooves into 50 pieces with respect to each sample, then placing the pieces in a net, and applying vibration to them in water from an ultrasonic vibrator. The ultrasonic vibration conditions were an oscillating frequency of 28 kHz, a power of 1.5 kW, and a time period of 10 minutes. The presence or absence of chipping was determined by observing the periphery of each piece with a tool maker's microscope at a magnification of 10x. The result of the evaluation of chipping is also shown in Table 2. Chipping was evaluated as described below. Referring to Fig. 9, cases where the piece has a chipped portion 34 of 0.4 mm or more in both length A and width B are expressed by "x" (poor); cases where the piece has a chipped portion 34 of less than 0.4 mm in both length A and width B are expressed by "Δ" (acceptable); and cases where no chipped portion is observed are expressed by "○."

### Evaluation of Transverse Strength

The transverse strength of a piece obtained by dividing the ceramic member along the grooves was measured using Digital Load Tester Model 1840D (manufactured by Aikoh Engineering Co., Ltd.). As shown in Fig. 10, the transverse strength was measured at a crosshead speed of 0.5 mm/minute with a span S of 30 mm. In the measurement method, each sample was placed with its grooved surface facing downward, and the load was applied to its back surface so that the profile of the periphery resulting from the grooves was most influenced by the transverse load. The result of the evaluation of the transverse strength is shown in Table 2.

### Measurement of the Content of Silica and Other Components

The content of silica was measured in the region located at depths ranging from 60 µm to 70 µm along the normal direction from the surface of the groove (a non-surface layer) and in the surface layer of the groove. The content of silica in the non-surface layer was measured by a process including etching the region located at depths ranging from 60 µm to 70 µm along the normal direction from the surface of the groove by FIB machining, while performing the measurement on a 50 µm square area using wavelength dispersive EPMA analysis. In the EPMA analysis, carbon or the like was vapor-deposited on the surface to be measured, and the measurement conditions were an accelerating voltage of 15 kV and a probe current of 3 × 10⁻⁷ A.

The content of silica in the surface layer of the groove was measured by wavelength dispersive EPMA analysis in a 50 µm square region located at a depth of 2 µm along the normal direction from the surface of the groove. In the EPMA analysis, carbon was vapor-deposited on the surface to be measured, and the measurement conditions were an accelerating voltage of 15 kV and a probe current of 3.0 × 10⁻⁷ A. The result of the measurement of the content in each of the non-surface layer and the surface layer of the groove is shown in Table 2. The average content of silica in the non-surface layer, the content of silica in the surface layer of the groove, and the ratio therebetween are shown together in Table 2.

The average content of each of alumina, calcia and magnesia in the non-surface layer was also measured by the same method as used for the average content of silica in the non-surface layer. The result of the measurement of the average content of them in the non-surface layer is also shown in Table 2.

### Cross-Sectional SEM Photography

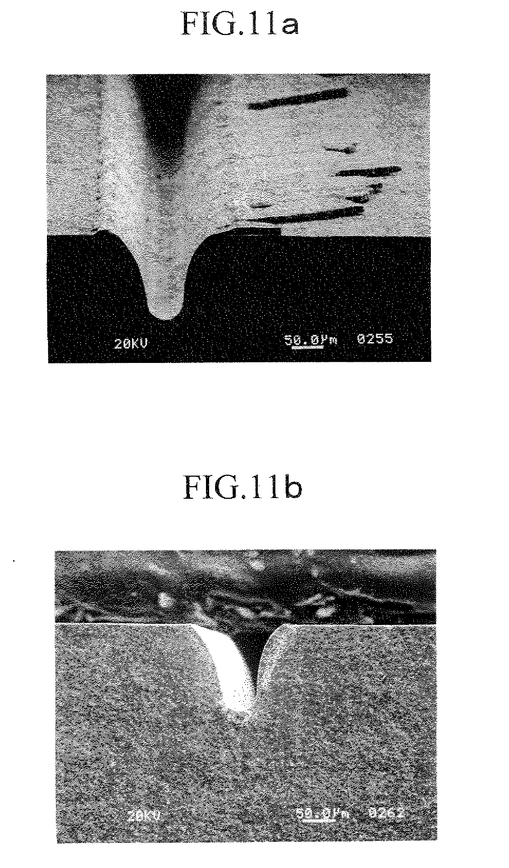

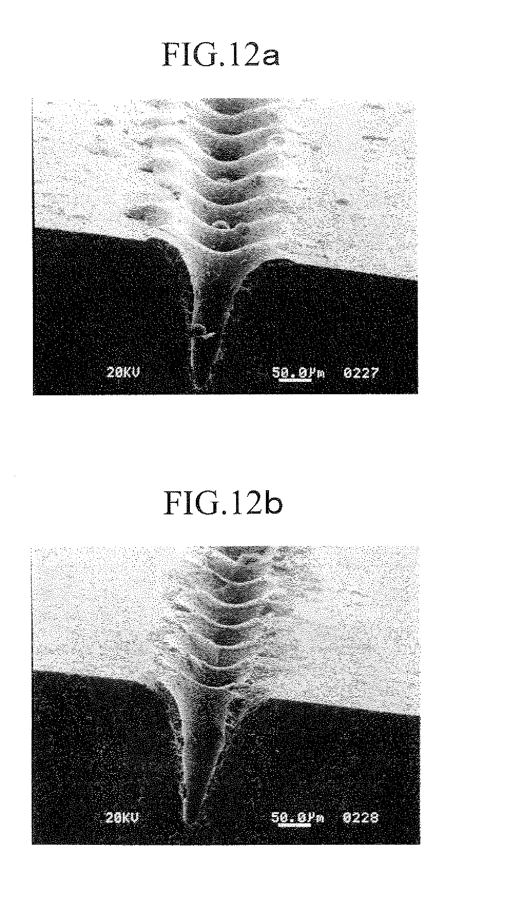

The cross-sectional SEM photography was performed on each of Sample Nos. 3 and 19, before and after the solidified melt was removed. C and Au were vapor-deposited on the sample, and an energy-dispersive electron reflection image was obtained at a magnification of 150× in the measurement. The results of the cross-sectional SEM photography are shown in Figs. 11(a) and 11(b) for Sample No. 3 and in Figs. 12(a) and 12(b) for Sample No. 19. Figs. 11(a) and 12(a) each show the state before the removal of the solidified melt, and Figs. 11(b) and 12(b) each show the state after the removal of the solidified melt.

Table 2

Table 2 shows that Sample Nos. 1 to 17 caused no chipping or an acceptable level of chipping and had practically-acceptable high transverse strength.

This result suggests that the temperature of the laser beam-irradiated portion should be from 2050°C to 2980°C in order to suppress chipping and ensure high transverse strength. In particular, Sample Nos. 2 to 4, 7 to 9, and 12 to 14 each produced using a laser beam-irradiated portion temperature of 2100°C to 2900°C caused no chipping and had high transverse strength. It has been found, therefore, that the temperature of the laser beam-irradiated portion is more preferably from 2100°C to 2900°C.

With respect to the moving speed of the laser beam-irradiated portion, chipping was suppressed and high transverse strength was ensured in Sample Nos. 1 to 17 each produced using a moving speed of 9 m/minute to 70 m/minute. In particular, Sample Nos. 2 to 4, 7 to 9, and 12 to 14 each produced using a moving speed of 10 m/minute to 60 m/minute caused no chipping and had high transverse strength. It has been found, therefore, that the moving speed of the laser beam-irradiated portion is preferably from 9 m/minute to 70 m/minute, more preferably from 10 m/minute to 60 m/minute.

A comparison between Sample Nos. 3, 16, and 17 shows that a pulse oscillation frequency of 10000 Hz or more for the laser beam irradiation can produce high transverse strength.

With respect to the content of silica in the surface layer of the groove and in the non-surface layer (the region located at depths ranging from 60 µm to 70 µm along the normal direction from the surface of the groove), the content of silica in the surface layer of the groove was 1.3 to 1.6 times higher than the average content of silica in the non-surface layer in Sample Nos. 1 to 17 resisting chipping and having high transverse strength.

In contrast, it was not possible to form grooves in Sample No. 18, because the temperature of the laser beam-irradiated portion was too low. In Sample No. 19, chipping and a reduction in transverse strength were found, because the moving speed was too low and the irradiation temperature was too high. In Sample No. 18, the content of silica in the surface layer of the groove was also lower than the average content of silica in the non-surface layer.

In order to suppress chipping and ensure high transverse strength, the content of silica in the surface layer of the groove should preferably be 1.2 to 1.6 times higher than the average content of silica in the whole of the non-surface layer.

Figs. 11(a) and 11(b) show that Sample No. 3 with no chipping and high transverse strength had good-locking continuous grooves whose surface and periphery were smooth. In contrast, Figs. 12(a) and 12(b) show that each of the grooves formed in Sample No. 38 looked like a perforated line and that the surface of the periphery of each groove was relatively rough after the removal of the solidified melt.

### Example 2

In this example, grooves were formed in a sintered ceramic material mainly including zirconia by applying a laser beam to the sintered ceramic material, and a study was performed on the influence of the temperature of the laser beam-irradiated portion on the transverse strength and chipping of a piece obtained by dividing the ceramic member along the grooves.

A ceramic member was produced under the same conditions as those in Example 1, except that a powder mixture of zirconia powder and yttria powder was used instead.

The grooves were formed under the same conditions as those in Example 1, except that the conditions shown in Table 3 were used.

Table 3

Chipping and the transverse strength were evaluated in the same manner as in Example 1. The results are shown in Table 4. The content of yttria was measured in the region located at depths ranging from 60 µm to 70 µm along the normal direction from the surface of the groove (a non-surface layer) and in the surface layer of the groove by the same method as that in Example 1. The result is shown in Table 4. The average content of yttria in the non-surface layer, the content of yttria in the surface layer of the groove, and the ratio therebetween are shown together in Table 4.

Table 4

Table 4 shows that Sample Nos. 20 to 36 caused no chipping or an acceptable level of chipping and had practically-acceptable high transverse strength.

This result suggests that the temperature of the laser beam-irradiated portion should be from 3300°C to 4400°C in order to suppress chipping and ensure high transverse strength. In particular, Sample Nos. 21 to 23, 26 to 28, and 31 to 33 each produced using a laser beam-irradiated portion temperature of 3350°C to 4300°C caused no chipping and had high transverse strength. It has been found, therefore, that the temperature of the laser beam-irradiated portion is more preferably from 3350°C to 4300°C.

With respect to the moving speed of the laser beam-irradiated portion, chipping was suppressed and high transverse strength was ensured in Sample Nos. 20 to 36 each produced using a moving speed of 9 m/minute to 70 m/minute. In particular, Sample Nos. 21 to 23, 26 to 28, and 31 to 33 each produced using a moving speed of 10 m/minute to 60 m/minute caused no chipping and had high transverse strength. It has been found, therefore, that the moving speed of the laser beam-irradiated portion is preferably from 9 m/minute to 70 m/minute, more preferably from 10 m/minute to 60 m/minute.

A comparison between Sample Nos. 23, 35, and 36 shows that a pulse oscillation frequency of 10,000 Hz or more for the laser beam irradiation can produce high transverse strength.

With respect to the content of silica in the surface layer of the groove and in the non-surface layer (the region located at depths ranging from 60 µm to 70 µm along the normal direction from the surface of the groove), the content of yttria in the surface layer of the groove was 1.3 to 1.6 times higher than the average content of yttria in the non-surface layer in Sample Nos. 1 to 17 resisting chipping and having high transverse strength.

In contrast, it was not possible to form grooves in Sample No. 38, because the temperature of the laser beam-irradiated portion was too low. In Sample No. 19, chipping and a reduction in transverse strength were found, because the moving speed was too low and the irradiation temperature was too high. In Sample No. 18, the content of yttria in the surface layer of the groove was also lower than the average content of yttria in the non-surface layer.

In order to suppress chipping and ensure high transverse strength, the content of yttria in the surface layer of the groove should preferably be 1.2 to 1.6 times higher than the average content of yttria in the non-surface layer.

## Claims

1. A ceramic member having a groove, comprising:
silica,
wherein the content of silica is higher in a region located at depths at least ranging from 1 to 10 µm along a normal direction from a surface of the groove than in an another region located at depths ranging from 60 µm to 70 µm along the normal direction from the surface of the groove.

2. The ceramic member according to claim 1, wherein the region located at depths at least ranging from 1 µm to 10 µm along the normal direction from the surface of the groove forms a surface layer, and
the content of silica in the surface layer is 1.2 to 1.6 times the average content of silica in the another region located at depths ranging from 60 µm to 70 µm along the normal direction from the surface of the groove.

3. The ceramic member according to claim 1, wherein the ceramic member comprises alumina as a main component.

4. The ceramic member according to claim 3, wherein the ceramic member has an average alumina content of 92.6% by mass to 99.6% by mass and an average silica content of 0.3% by mass to 5.0% by mass.

5. The ceramic member according to claim 4, further comprising calcia and magnesia, wherein
the ceramic member has an average calcia content of 0% by mass to 0.4% by mass and an average magnesia content of 0.1% by mass to 2.0% by mass.

6. The ceramic member according to clam 1, wherein the ceramic member is capable of being divided into a plurality of substrates for electronic parts along the groove.

7. A ceramic member having a groove, comprising:
yttria,
wherein the content of yttria is higher in a region located at depths at least ranging from 1 to 10 µm along a normal direction from the surface of the groove than in an another region located at depths ranging from 60 µm to 70 µm along the normal direction from the surface of the groove.

8. The ceramic member according to claim 7, wherein the region located at depths at least ranging from 1 µm to 10 µm along the normal direction from the surface of the groove forms a surface layer, and
the content of yttria in the surface layer is 1.2 to 1.6 times the average content of yttria in the another region located at depths ranging from 60 µm to 70 µm along the normal direction from the surface of the groove.

9. The ceramic member according to claim 7, wherein the ceramic member comprises zirconia as a main component.

10. The ceramic member according to claim 9, wherein the region located at depths ranging from 60 µm to 70 µm along the normal direction from the surface of the groove has an average zirconia content of 94.2% by mass to 94.8% by mass and an average yttria content of 5.2% by mass to 5.8% by mass.

11. The ceramic member according to claim 7, wherein the ceramic member is capable of being divided into a plurality of substrates for electronic parts along the groove.

12. A method of forming a groove in a ceramic member, comprising:
applying a heat ray to a surface of the ceramic member, while blowing gas thereto; and
moving the heat ray,
wherein the ceramic member comprises alumina as a main component and silica, and
a portion to which the heat ray is applied has a temperature of 2050°C to 2980°C.

13. The method of forming the groove in the ceramic member according to claim 12, wherein the portion to which the heat ray is applied has a temperature of 2100°C to 2900°C.

14. The method of forming the groove in the ceramic member according to claim 12, wherein the heat ray is moved at a speed of 9 m/minute to 70 m/minute.

15. The method of forming the groove in the ceramic member according to claim 14, wherein the heat ray is moved at a speed of 10 m/minute to 60 m/minute.

16. The method of forming the groove in the ceramic member according to claim 12, wherein the heat ray has a frequency of 10000 Hz or more.

17. The method of forming the groove in the ceramic member according to claim 12, wherein the heat ray is a laser beam.

18. The method of forming the groove in the ceramic member according to claim 12, wherein the gas is blown from a direction oblique to a normal direction of the surface of the ceramic member.

19. The method of forming the groove in the ceramic member according to claim 18, wherein the gas is blown from a direction making an angle of 15° to 75° with the normal direction.

20. A method of forming a groove in a ceramic member, comprising:
applying a heat ray to a surface of the ceramic member, while blowing gas thereto; and
moving the heat ray,
wherein the ceramic member comprises zirconia as a main component and yttria, and
a portion to which the heat ray is applied has a temperature of 3300°C to 4400°C.

21. The method of forming the groove in the ceramic member according to claim 20, wherein the portion to which the heat ray is applied has a temperature of 3350°C to 4300°C.

22. The method of forming the groove in the ceramic member according to claim 20, wherein the heat ray is moved at a speed of 9 m/minute to 70 m/minute.

23. The method of forming the groove in the ceramic member according to claim 22, wherein the heat ray is moved at a speed of 10 m/minute to 60 m/minute.

24. The method of forming the groove in the ceramic member according to claim 20, wherein the heat ray is a laser beam.

25. The method of forming the groove in the ceramic member according to claim 20, wherein the heat ray has a frequency of 10000 Hz or more.

26. The method of forming the groove in the ceramic member according to claim 20, wherein the gas is blown in a direction oblique to a normal direction of the surface of the ceramic member.

27. The method of forming the groove in the ceramic member according to claim 26, wherein the gas is blown in a direction making an angle of 15° to 75° with the normal direction.

28. A substrate for electronic parts, comprising:
a ceramic member comprising silica,
wherein in at least part of a peripheral portion on at least one of the main side and the back side of the substrate, the content of silica is higher in the region located at depths at least ranging from 1 to 10 µm along a normal direction from a surface of a groove than in the another region located at depths ranging from 60 µm to 70 µm along the normal direction from a surface of a groove.

29. A substrate for electronic parts, comprising:
a ceramic member comprising yttria,
wherein in at least part of a peripheral portion on at least one of the main side and the back side of the ceramic member, the content of yttria is higher in the region located at depths at least ranging from 1 to 10 µm along a normal direction from a surface of a groove than in the another region located at depths ranging from 60 µm to 70 µm along the normal direction from a surface of a groove.

## Amended claims

### Amended claims under Art. 19.1 PCT

**1.** (Amended) A ceramic member having a groove, comprising: silica,
wherein a content of silica is higher in a surface layer which is a region located at depths at least ranging from 1 to 10 µm along a normal direction from a surface of the groove than in an another region located at depths ranging from 60 µm to 70µm along the normal direction from the surface of the groove and the content of silica in the surface layer is 1.2 to1.6 times an average content of silica in the another region.

**2.** (deleted)

**3.** The ceramic member according to claim 1, wherein the ceramic member comprises alumina as a main component.

**4.** The ceramic member according to claim 3, wherein the ceramic member has an average alumina content of 92.6%by mass to 99.6% by mass and an average silica content of 0.3% by mass to 5.0% by mass.

**5.** (Amended) The ceramic member according to claim 4, further comprising calcia and magnesia, wherein the ceramic member has an average calcia content of 0 % by mass to 0,4% by mass and an average magnesia content of 0.1% by mass to 2.0% by mass.

**6.** The ceramic member according to claim 1, wherein the ceramic member is capable of being divided into a plurality of substrates for electronic parts along the groove.

**7.** (Amended) A ceramic member having a groove, comprising: yttria,
wherein a content of yttria is higher in a surface layer which is a region located at depths at least ranging from 1 to 10 µm along a normal direction from a surface of the groove than in an another region located at depths ranging from 60 µm to 70µm along the normal direction from the surface of the groove and the content of yttria in the surface layer is 1.2 to1.6 times an average content of yttria in the another region.

**8.** (deleted)

**9.** The ceramic member according to claim 7, wherein the ceramic member comprises zirconia as a main component.

**10.** The ceramic member according to claim 9, wherein the region located at depths ranging from 60 µm to 70 µm along the normal direction from the surface of the groove has an average zirconia content of 94.2% by mass to 94.8% by mass and an average yttria content of 5.2% by mass to 5.8% by mass.

**11.** The ceramic member according to claim 7, wherein the ceramic member is capable of being divided into a plurality of substrates for electronic parts along the groove.

**12.** A method of forming a groove in a ceramic member, comprising:
applying a heat ray to a surface of the ceramic member, while blowing gas thereto; and
moving the heat ray,
wherein the ceramic member comprises alumina as a main component and silica, and
a portion to which the heat ray is applied has a temperature of 2050°C to 2980°C.

**13.** The method of forming the groove in the ceramic member according to claim 12, wherein the portion to which the heat ray is applied has a temperature of 2100°C to 2900°C.

**14.** The method of forming the groove in the ceramic member according to claim 12, wherein the heat ray is moved at a speed of 9 m/minute to 70 m/minute.

**15.** The method of forming the groove in the ceramic member according to claim 14, wherein the heat ray is moved at a speed of 10 m/minute to 60 m/minute.

**16.** The method of forming the groove in the ceramic member according to claim 12, wherein the heat ray has a frequency of 10000 Hz or more.

**17.** The method of forming the groove in the ceramic member according to claim 12, wherein the heat ray is a laser beam.

**18.** The method of forming the groove in the ceramic member according to claim 12, wherein the gas is blown from a direction oblique to a normal direction of the surface of the ceramic member.

**19.** The method of forming the groove in the ceramic member according to claim 18, wherein the gas is blown from a direction making an angle of 15° to 75° with the normal direction.

**20.** A method of forming a groove in a ceramic member comprising:
applying a heat ray to a surface of the ceramic member, while blowing gas thereto; and
moving the heat ray,
wherein the ceramic member comprises zirconia as a main component and yttria, and
a portion to which the heat ray is applied has a temperature of 3300°C to 4400°C.

**21.** The method of forming the groove in the ceramic member according to claim 20, wherein the portion to which the heat ray is applied has a temperature of 3350°C to 4300°C.

**22.** The method of forming the groove in the ceramic member according to claim 20, wherein the heat ray is moved at a speed of 9 m/minute to 70 m/minute.

**23.** The method of forming the groove in the ceramic member according to claim 22, wherein the heat ray is moved at a speed of 10 m/minute to 60 m/minute.

**24.** The method of forming the groove in the ceramic member according to claim 20, wherein the heat ray is a laser beam.

**25.** The method of forming the groove in the ceramic member according to claim 20, wherein the heat ray has a frequency of 10000 Hz or more.

**26.** The method of forming the groove in the ceramic member according to claim 20, wherein the gas is blown in a direction oblique to a normal direction of the surface of the ceramic member.

**27.** The method of forming the groove in the ceramic member according to claim 26, wherein the gas is blown in a direction making an angle of 15° to 75° with the normal direction.

**28.** (Amended) A substrate for electronic parts, comprising:
a ceramic member comprising silica,
wherein in at least part of a peripheral portion on at least one of the main side and the back side of the substrate, the content of silica in a region located at depths at least ranging from 1 to 10 µm along a normal direction from a surface of a groove is 1.2 to1.6 times an average content of silica in an another region located at depths ranging from 60 µm to 70 µm along the normal direction from a surface of a groove.

**29.** (Amended) A substrate for electronic parts, comprising:
a ceramic member comprising yttria,
wherein in at least part of a peripheral portion on at least one of the main side and the back side of the substrate, the content of yttria in a region located at depths at least ranging from 1 to 10 µm along a normal direction from a surface of a groove is 1.2 to 1.6 times an average content of yttria in an another region located at depths ranging from 60 µm to 70 µm along the normal direction from a surface of a groove.
